Europäisches Patentamt

European Patent Office

Office européen des brevets

(19)

(11) Publication number: **0 020 778**

**B1**

(12) **EUROPEAN PATENT SPECIFICATION**

(45) Date of publication of patent specification: **07.12.83**

(21) Application number: **79901519.3**

(22) Date of filing: **06.11.79**

(86) International application number:
**PCT/JP79/00285**

(87) International publication number:
**WO 80/01124 29.05.80 Gazette 80/12**

(51) Int. Cl.³: **H 03 F 3/16, H 03 F 3/72, H 04 B 1/06**

(54) **AMPLIFIER CIRCUIT.**

(30) Priority: **17.11.78 JP 142533/78**

(43) Date of publication of application:
**07.01.81 Bulletin 81/1**

(45) Publication of the grant of the patent:
**07.12.83 Bulletin 83/49**

(84) Designated Contracting States:
**DE FR GB**

(56) References cited:
**JP - A - 53 076 719**
**JP - B - 43 006 565**
**JP - Y - 53 033 494**
**US - A - 4 068 090**

**"CMOS IC HANDBOOK"** Second print, (1976-7-1) KABUSHIKI KAISHA ELECTRONICS DIGEST, P. 222 (Fig. 8-50), Compiled by Motorola Semiconductors Japan Kabushiki Kaisha
RCA REVIEW, vol. 37, no. 1, March 1976, pp. 136-148, R.C.A. Corp. Princeton, S.T. HSU: "A COS/MOS linear amplifier stage"

(73) Proprietor: **FUJITSU LIMITED**
**1015, Kamikodanaka Nakahara-ku**
**Kawasaki-shi Kanagawa 211 (JP)**

(72) Inventor: **ASAMI, Fumitaka**
**27, Fujimidai 1-chome**
**Kunitachi-shi, Tokyo, 186 (JP)**

(74) Representative: **Bedggood, Guy Stuart**
**Haseltine Lake & Co. Hazlitt House 28**
**Southampton Buildings Chancery Lane**
**London WC2A 1AT (GB)**

Courier Press, Leamington Spa, England.

Amplifier circuit

This invention relates to an amplifier circuit, more particularly to an amplifier circuit wherein a couple of inverters are cascade-connected and the second inverter is used in such a condition that it is so biased that the highest gain is obtained, by connecting a resistor (including the case where resistance is zero) between input and output terminals of the first inverter.

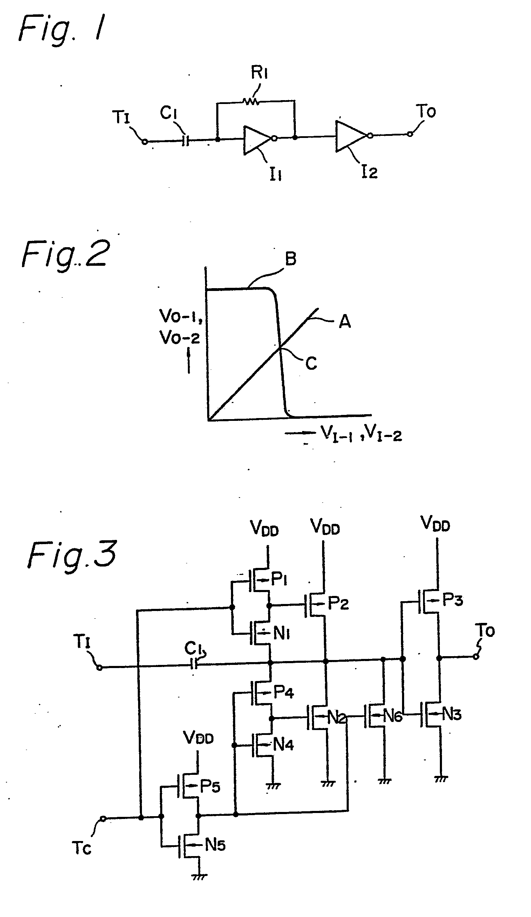

A conventional amplifier circuit using a pair of inverters is shown in Figure 1 of the accompanying drawings.

In Figure 1, an input signal to an input terminal $T_i$ is applied to an input of an inverter $I_1$ via a capacitor $C_1$. Between input and output terminals of inverter $I_1$ a resistor $R_1$ is connected. An output of the inverter $I_1$ is output to a terminal $T_0$ via an inverter $I_2$.

The relationship between input and output of each inverter of an amplifier circuit as shown in Figure 1 is illustrated in Figure 2.

In Figure 2, A illustrates a relationship between an input $V_{I-1}$ and an output $V_{0-1}$ of inverter $I_1$. The input-output characteristic A of the inverter $I_1$ is generally expressed by a straight line, since a negative feedback loop is provided for the inverter $I_1$. In particular, when the resistance $R_1$ is zero (0), $V_{I-1}$ is equal to $V_{0-1}$, and the characteristic A is a straight line having inclination of 45°. On the other hand, B illustrates the relationship between an input $V_{I-2}$ and an output $V_{0-2}$ of inverter $I_2$. The gain of inverter $I_2$ is very high since it has no feedback loop. By the way, as is apparent from Figure 1, $V_{0-1}$ equals $V_{I-2}$.

A point C at which the characteristics A and B intersect indicates a bias point of the input of inverter $I_2$, and it is shown that the point C is set to the centre of the characteristic B where the highest gain can be obtained by making the resistance $R_1$ zero. Therefore, a large variation of output $V_{0-2}$ can be extracted from a small change of input $V_{I-1}$. As explained above, an amplifier circuit can be realized, in which an inverter is used in such a way that the gain is at a maximum. The same characteristics can easily be attained for both inverters, for example when CMOS is used, by making the gain constants $\beta$ of the inverters equal.

By the way, the great progress in manufacturing technology of semiconductor devices has promoted high level integration of semiconductor elements, to a degree permitting circuits of different functions, existingly formed on individual semiconductor chips, to be formed on the same semiconductor chip.

For example, considering a car radio receiver and a timer (in particular a digital timer) mounted in a vehicle, the following integrated circuits come to mind.

A car radio receiver provides a phase locked loop (generally called PLL) circuit for tuning and this PLL circuit has a frequency divider which converts an oscillation signal sent from a crystal controlled oscillator to a desired frequency signal and an input amplifier circuit having a construction as mentioned above, for generating a local oscillation signal.

Formation of a PLL circuit, composed of circuits having different functions, on one semiconductor chip makes the manufacture of a car radio very easy.

On the other hand, a timer also requires a crystal oscillator generating a stabilized oscillation frequency and a divider for obtaining a desired frequency signal, in order to sequentially operate a counter.

Thus, total construction can be simplified by using one crystal controlled oscillator in common and by using a common part of a divider for a car radio and timer.

However, there is a great difference between the ways in which a car radio and timer are used.

A car radio is switched on when a driver or a person desires to listen to a radio program, and is switched off when the driver leaves the car, for example.

On the other hand, a timer must operate continuously without reference to a driver or person's attendance, for convenience when it is desired to know the present time.

For this reason, when using a divider circuit of a PLL circuit in common for a car radio and timer, the power supply of an integrated circuit must not be switched off even when a driver or person is not listening to the car radio.

However, when an input amplifier circuit of the PLL circuit is a CMOS (Complimentary Metal Oxide Semiconductor) circuit p channel transistors and n channel transistors in each inverter and in internal circuits simultaneously become conductive, allowing a steady current to flow, and thereby an input amplifier circuit consumes much electrical power even when a car radio is not operated.

This represents a serious disadvantage for car electronics devices which use a battery for power supply.

United States Patent No. 4,068,090 discloses a hearing aid having a microphone, an amplifier for amplifying signals from the microphone, and a loudspeaker or earphone for producing sound representative of the amplified signals from the microphone. An amplifier using C-MOS inverter amplifier circuitry is disclosed. A connecting circuit for connecting the amplifier to a low impedance loudspeaker or earphone is disclosed which operates in class B and is such that when no signal is amplified current load is negligible. This is obtained by shifting voltage bias to a vicinity of the threshold voltage of p-channel and n-channel driving transistors of the connecting circuit which are connected drain to drain.

The paper "A COS/MOS Linear Amplifier Stage", by S. T. Hsu, from the journal RCA REVIEW, Vol. 37, March 1976, discloses an amplifier circuit including first and second inverters cascade connected and in each of which a p-channel transistor and an n-channel transistor are connected in series.

According to the present invention there is provided an amplifier circuit including first and second inverters which are cascade connected and in each of which a p channel transistor and a n channel transistor are connected in series, characterised in that an input line of the first inverter is connected to the drains of the transistors thereof, first means are provided which are operable to connect the gates of both transistors of the first inverter to their respective drains when the amplifier circuit is being operated as an amplifier, second means are provided which are operable to connect the gates of both transistors of the first inverter to a potential which sets both those transistors in a cut-off condition when the amplifier circuit is not being operated as an amplifier, and the second inverter is provided with third means which are operable to set either of the p channel and n channel transistors of the second inverter in a cut-off condition when the amplifier circuit is not being operated as an amplifier.

It is an object of the present invention to offer an amplifier circuit such that power consumption can be reduced, without switching off the power source, when it is not operated.

According to an embodiment of the present invention, there are provided, in an amplifier circuit comprising first and second cascade-connected inverters for each of which p channel and n channel transistors are connected in series, first and second control transistors which become conductive when a specified control voltage is applied and which then connect the gates of the two transistors forming the first inverter to their respective drains, and third and fourth control transistors which become conductive when the specified control voltage is not applied and which then connect the gates of the two transistors forming the first inverter to power supply or ground respectively, and a fifth control transistor which becomes conductive when the specified control voltage is not applied and which then fixes the gates of both transistors of the second inverter to power source or ground potential, whereby power consumption can be drastically reduced without switching off the power supply, whilst the amplifier circuit is not being operated.

Reference is made, by way of example, to the accompanying drawings, in which:—

Figure 1 illustrates a construction of an existing amplifier using an inverter,

Figure 2 illustrates characteristics indicating relationships between input and output in the amplifier circuit shown in Figure 1,

Figure 3 is a schematic diagram illustrating construction of an embodiment of the present invention, and

Figure 4 is a schematic diagram of a radio receiver wherein the amplifier circuit of Figure 3 is adopted.

A preferred embodiment of the present invention will be explained hereunder with reference to Figure 3.

In Figure 3, $P_1$, $P_2$, $P_3$, $P_4$ and $P_5$ denote p channel transistors; $N_1$, $N_2$, $N_3$, $N_4$, $N_5$ and $N_6$ denote n channel transistors; $C_1$ denotes a capacitor; $T_1$ denotes an input terminal; $T_0$ denotes an output terminal; $T_c$ denotes a control terminal; $V_{DD}$ denotes a positive power supply.

Transistors $P_2$, $N_2$ and $P_3$, $N_3$ are so configurated that gain constants $\beta$ are equal respectively. The transistors $P_2$, $N_2$ operate as a first inverter, while the transistors $P_3$, $N_3$ operate as a second inverter.

The construction wherein the gates of transistors $P_2$, $N_2$ of the first inverter are connected to respective drains is a more practical circuit illustrating the existing amplifier circuit shown in Figure 1.

Different from such an existing amplifier circuit, an amplifier circuit embodying the present invention comprises first and second control transistors $N_1$ and $P_4$ connected to the gates of transistors $P_2$ and $N_2$ and which become conductive when a specified control signal (high level) is applied to the control terminal $T_c$ and connect the first inverter transistor gates to their respective drains, third and fourth control transistors $P_1$ and $N_4$ connected to the gates of transistors $P_2$ and $N_2$ and which become conductive when the specified control signal is low level (that is, when the specified control signal is not applied) and connect the first inverter transistor gates respectively to the power supply $V_{DD}$ or ground, and a fifth transistor $N_6$ which fixes the gates of both transistors $P_3$ and $N_3$ which become conductive when the control signal is low level (that is, when the control signal is not applied) and connect the second inverter to ground potential (or power supply voltage $V_{DD}$), and an inverter consisting of transistors $P_5$ and $N_5$ which operates the control transistors as mentioned above.

In order to operate the circuit as shown in Figure 3 as an amplifier, it is necessary to apply a high level signal to the control terminal $T_c$. Thereby, the transistors $N_1$, $P_4$ become conductive, making conductive connection from the gates of transistors $P_2$, $N_2$ to their respective drains.

Therefore, the input and output of the first inverter consisting of transistors $P_2$, $N_2$ are terminated (connected) and thereby an input voltage becomes equal to an output voltage as in the case of the inverter $I_1$ in Figure 1. Since the first inverter consisting of transistors $P_2$, $N_2$ and the second inverter consisting of transistors $P_3$, $N_3$ have the same gain constant $\beta$,

the second inverter consisting of transistors $P_3$, $N_3$ is so biased that the highest gain is obtained as explained above and operates as the required input amplifier.

When it is not required to operate the circuit of Figure 3 as an amplifier, it is necessary to apply a low level signal to the control terminal $T_c$. Thereby, an output of the inverter consisting of transistors $P_5$, $N_5$ becomes high level. Therefore, transistors $P_1$, $N_4$ become conductive, setting transistors $N_1$, $P_4$ to the cut-off condition. Thus, the gates of transistors $P_2$ and $N_2$ are set to the cut-off condition because these gates are respectively connected to the power source $V_{DD}$ and ground and as a result a current does not flow between the power supply and ground via the first inverter.

Simultaneously, the transistor $N_6$ becomes conductive and an input of the second inverter consisting of transistors $P_3$ and $N_3$ becomes low level, thereby an output of the second inverter at the terminal $T_0$ is fixed at a high level. As a result, current does not flow between the power supply and ground via the second inverter. With the input of the second inverter fixed to low level by the transistor $N_6$, flow of current between the power supply and ground via the second inverter consisting of transistors $P_3$, $N_3$ is prevented.

If transistor $N_6$ is not provided to fix the potential of the input of the second inverter, the interim point of transistors $N_2$, $P_2$, the potential of the input becomes unstable (floats) when transistors $P_2$, $N_2$ are cut-off.

The output of the second inverter at the terminal $T_0$ may alternatively be set to a low level (when transistor $N_6$ becomes conductive) by connecting the transistor $N_6$ between the interim point of transistors $N_2$, $P_2$ and the power supply. In this case also, with the input of the second inverter fixed to high level, current is prevented from flowing between power supply and ground via the second inverter.

When circuitry following the amplifier circuit of Figure 3 uses CMOS an output of the terminal $T_0$, fixed to high level or low level, can be used to set either a CMOS p-channel transistor or n-channel transistor, as appropriate, in a cut-off condition. This can be used to reduce power consumption in the following circuitry. From this point of view, the embodiment of the present invention described above is particularly effective when adopted in an integrated circuit device constructed using CMOS.

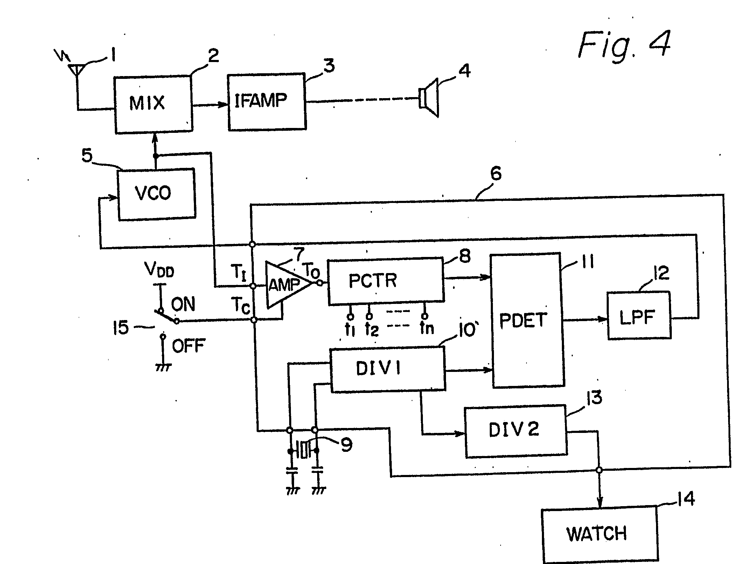

Figure 4 is a preferred embodiment of a circuit adopting an amplifier circuit as shown in Figure 3 and particularly relates to a divider circuit of a PLL circuit of a radio receiver used in common as a part of a divider circuit of a timer.

The PLL circuit comprises a voltage controlled oscillator 5, an input amplifier circuit 7, a program counter 8, a crystal controlled oscillator 9, a divider circuit 10, a phase detection circuit 11 and a low pass filter 12.

In the program counter 8 of the PLL circuit, when a listener selects a program, a signal is applied to a specified terminal according to the selected program (broadcasting station) among the terminals $t_1$, $t_2$ ... $t_n$, and then a dividing ratio of the program counter 8 is set.

An input signal is frequency-converted in accordance with a signal applied to the terminal $t_1$, $t_2$ ... $t_n$ by means of the program counter and is then subjected to phase comparison at the phase detection circuit 11 with a signal obtained by dividing the output of crystal controlled oscillator 9.

If an output frequency of the voltage controlled oscillator 5 varies from a frequency of the specified local oscillation signal, an output is detected from the phase detection circuit 11 and it is then applied to the voltage ontrolled oscillator 5 via a low pass filter 12.

Therefore, the voltage controlled oscillator 5 is controlled by the detected output, causing the output frequency to be shifted to the specified local oscillation signal frequency.

Since a stable local oscillation signal is thus applied to the mixer 2, a broadcast signal received through the antenna 1 is output from a loud speaker 4 in a satisfactory condition via an ordinary receiving circuit comprising the mixer 2 and intermediate frequency amplifier circuit 3 etc. On the other hand, the crystal controlled oscillator 9 in this PLL circuit is also used as a block pulse generation source of a timer.

A signal sent from the crystal controlled oscillator 9 is input to the divider circuit 10, and the output of 10 is then input to the phase detection circuit 11 as already explained. The desired divided signal is moreover input to the divider circuit 13 of a timer and is further divided in frequency to provide a 1-second clock signal which drives a timer circuit 14.

Although not illustrated, in the timer circuit 14, the counter receives the clock signal of a 1-second period and simultaneously an indicator using liquid crystal displays the content of the counter.

When configurating such circuit construction, if block 6 including input amplifier circuit 7, program counter 8, divider circuits 10 and 13, phase detection circuit 11 and low pass filter 12 is formed on one semiconductor chip, the power source being applied to the chip cannot be turned OFF because the divider circuits 10, 13 must be operated even while no one is listening to the radio receiver.

When an amplifier circuit embodying the present invention, as shown in Figure 3, is used as an input amplifier circuit 7 by connecting the input terminal $T_1$ to the output terminal of the voltage control oscillator 5 and by connecting the output terminal $T_0$ to the input terminal of program counter 8, the amplifier circuit can be set in a non-operative condition by inputting a low level signal to the control terminal $T_c$ when the radio is not being listened to, thus power consumption can be reduced without switching off the power supply.

Here, the control signal to be applied to the control terminal can be produced by using, for example, a power switch 15 of the radio receiver as shown in Figure 4. Namely, when the power switch is turned ON, the contact of switch 15 is set to an ON side and a power source voltage $V_{DD}$ (high level) is applied to the control terminal $T_C$, and when the power switch is turned OFF, the contact of switch 15 is set to an OFF side and a ground potential (low level) is applied to the control terminal $T_C$. Moreover, it is also possible to employ, in addition to the power switch, tactics such as the application of a high level signal to the control terminal $T_C$, when the start key of the vehicle is keyed in, and the application of a low level signal when the start key is removed.

As explained above, an amplifier circuit embodying the present invention is capable of exhibiting the following excellent effects; it operates as an amplifier circuit using an inverter when a high level signal is applied to a control terminal; it does not operate as an amplifier when a low level signal is applied to the control terminal, preventing flow of current between power supply and ground via an inverter of the amplifier circuit; and thereby preventing unwanted power consumption when it is not operated as an amplifier.

## Claims

1. An amplifier circuit including first ($P_2$, $N_2$) and second ($P_3$, $N_3$) inverters which are cascade connected and in each of which a p channel transistor ($P_2$, $P_3$) and a n channel transistor ($N_2$, $N_3$) are connected in series, characterised in that an input line of the first inverter is connected to the drains of the transistors thereof, first means are provided which are operable to connect the gates of both transistors of the first inverter to their respective drains when the amplifier circuit is being operated as an amplifier, second means are provided which are operable to connect the gates of both transistors of the first inverter to a potential which sets both those transistors in a cut-off condition when the amplifier circuit is not being operated as an amplifier, and the second inverter is provided with third means ($N_6$) which are operable to set either of the p channel and n channel transistors of the second inverter in a cut-off condition when the amplifier circuit is not being operated as an amplifier.

2. An amplifier circuit as claimed in claim 1, wherein the first means comprises a pair of transistors, one of which is connected between the gate of the p channel tramsistor and the input line of the first inverter, and the other of which is connected between the gate of the n channel transistor and the input line of the first inverter.

3. An amplifier circuit as claimed in claim 1 or 2, wherein the second means comprises a pair of transistors connected respectively between the gates of the p channel and n channel transistors of the first inverter and a power supply or ground.

4. An amplifier circuit as claimed in claim 1, 2 or 3, wherein the third means comprises a transistor connected between an input line of the second inverter and a power supply or ground.

5. A radio receiver and a clock in combination, employing in common a semiconductor chip having an amplifier circuit as claimed in any preceding claim formed thereon, which amplifier circuit functions in an amplifying mode when said radio receiver and said clock are both operated but not when said clock is operated alone.

## Patentansprüche

1. Verstärkerschaltung mit ersten ($P_2$, $N_2$) und zweiten ($P_3$, $N_3$) Invertern, welche in Kaskade geschaltet sind und in denen jeweils ein P-Kanal-Transistor ($P_2$, $P_3$) und ein N-Kanal-Transistor ($N_2$, $N_3$) in Reihe geschaltet sind, dadurch gekennzeichnet, daß eine erste Eingangsleitung von dem ersten Inverter mit den Drainanschlüssen desselben Transistors verbunden ist, daß eine erste Einrichtung vorgesehen ist, welche betrieben werden kann, um die Gateanschlüsse der beiden Transistoren des ersten Inverters mit ihren entsprechenden Drainelektroden zu verbinden, wenn die Verstärkerschaltung als Verstärker betrieben wird, daß eine zweite Einrichtung vorgesehen ist, welche betrieben werden kann, um die Gateelektroden der beiden Transistoren des ersten Inverters mit einem Potential zu verbinden, welches die beiden Transistoren in den Sperrzustand versetzt, wenn die Verstärkerschaltung nicht als ein Verstärker betrieben wird, und daß der zweite Inverter eine dritte Einrichtung ($N_6$) umfaßt, welche betrieben werden kann, um entweder den P-Kanal-Transistor oder den N-Kanal-Transistor des zweiten Inverters in den Sperrzustand zu setzen, wenn die Verstärkerschaltung nicht als ein Verstärker betrieben wird.

2. Verstärkerschaltung nach Anspruch 1, bei welcher die erste Einrichtung ein Paar von Transistoren umfaßt, von denen einer zwischen der Gateelektrode des P-Kanal-Transistors und der Eingangsleitung des ersten Inverters und der andere Transistor zwischen der Gateelektrode des N-Kanal-Transistors und der Eingangsleitung des ersten Inverters geschaltet ist.

3. Verstärkerschaltung nach Anspruch 1 oder 2, bei welcher die zweite Einrichtung ein Paar von Transistoren umfaßt, welche jeweils zwischen den Gateelektroden des P-Kanal-Transistors und des N-Kanal-Transistors des ersten Inverters und einer Energieversorgung oder Masse geschaltet sind.

4. Verstärkerschaltung nach einem der Ansprüche 1, 2 oder 3, bei welcher die dritte Einrichtung einen Transistor umfaßt, welcher zwischen einer Eingangsleitung des zweiten Inverters und einer Energieversorgung oder Masse liegt.

5. Kombination aus Radioempfänger und Uhr, welche gemeinsam ein Halbleiterchip verwenden, auf welchem eine Verstärkerschaltung nach einem der vorhergehenden Ansprüche ausgebildet ist, welche im Verstärkungsmodus arbeitet, wenn der genannte Radioempfänger und die genannte Uhr beide in Betrieb sind, jedoch nicht, wenn die Uhr allein in Betrieb ist.

## Revendications

1. Circuit amplificateur comprenant des premier, $(P_2, N_2)$ et second $(P_3, N_3)$ inverseurs qui sont connectés en cascade et dans chacun desquels un transistor $(P_2, P_3)$ à canal P et un transistor $(N_2, N_3)$ à canal N sont connectés en série, caractérisé en ce qu'une ligne d'entrée du premier inverseur est connectée aux drains de ses transistors, un premier dispositif étant prévu qui a pour fonction de connecter des grilles des deux transistors du premier inverseur à leurs drains respectifs quand le circuit amplificateur fonctionne comme un amplificateur, un second dispositif étant prévu ayant pour fonction de connecter les grilles des deux transistors du premier inverseur à un potentiel qui place ces deux transistors en condition de blocage quand le circuit amplificateur ne fonctionne pas comme un amplificateur, et le second inverseur étant muni d'un troisième dispositif $(N_6)$ ayant

pour fonction de placer l'un ou l'autre des transistors à canal P et à canal N du second inverseur en condition de blocage quand le circuit amplificateur ne fonctionne pas comme un amplificateur.

2. Circuit amplificateur selon la revendication 1, dans lequel le premier dispositif comporte une paire de transistors dont l'un est connecté entre la grille du transistor à canal P et la ligne d'entrée du premier inverseur et dont l'autre est connecté entre la grille du transistor à canal N et la ligne d'entrée du premier inverseur.

3. Circuit amplificateur selon la revendication 1 ou 2, dans lequel le second dispositif comporte une paire de transistors connectés respectivement entre les grilles des transistors à canal P et à canal N du premier inverseur et une source d'alimentation ou la masse.

4. Circuit amplificateur selon la revendication 1, 2 ou 3, dans lequel le troisième dispositif consiste en un transistor connecté entre une ligne d'entrée du second inverseur et une source d'alimentation ou la masse.

5. Récepteur de radiophonie et horloge en combinaison, utilisant en commun une pastille semi-conductrice comprenant un circuit amplificateur selon l'une quelconque des revendications précédentes formé sur elle, ce circuit amplificateur fonctionnant dans un mode d'amplification quand ledit récepteur de radiophonie et ladite horloge fonctionnent tous deux mais non lorsque ladite horloge fonctionne seule.

*Fig. 1*

*Fig.2*

*Fig.3*

Fig. 4

0020778